# EUROPEAN PATENT SPECIFICATION

(11) **EP 0 328 417 B1**
(45) Date of publication and mention of the grant of the patent: **26.04.1995**
(21) Application number: 89301316.9
(22) Date of filing: 13.02.1989
(51) Int. Cl.: C23C 16/48, C23C 16/44, C23C 16/50

(54) **Apparatus for semiconductor process including photo-excitation process**
Anlage für Halbleiterverfahren einschliesslich eines photochemischen Verfahrens
Appareil pour procédé semi-conducteur incluant procédé par réaction photochimique

(30) Priority: 12.02.1988 JP 31511/88
(43) Date of publication of application: 16.08.1989
(73) Proprietor: Suda, Toshikazu, Yokohama-shi Kanagawa-pref. (JP); PLEXTOR CO., LTD., Tokyo (JP)
(72) Inventor: Suda, Toshikazu, Kanagawa-ku Yokohama-shi Kanagawa-pref. (JP)
(74) Representative: Newstead, Michael John

(56) References cited:
- US-A- 3 717 439
- US-A- 4 649 859
- US-A- 4 715 318

## Description

The present invention relates to apparatus for use in manufacturing a semiconductor device, such as one used in an integrated circuit, an optoelectronic device, or the like.

In the prior art, the plasma process has been used for the low temperature processing of semiconductors used in integrated circuits, optoelectronic devices, or the like. However, it has been impossible to avoid radiation damage caused by high energy particles, such as ions and electrons, that are generated by the plasma process. This has led in recent years to the use of a photo-excitation process, a non-damage process that utilises a photochemical reaction. The photo-excitation process is a technique whereby optical energy is used to excite a reaction gas and promote a chemical reaction for gas phase growth, etching, doping and ashing, for example. Such photo-excitation apparatus consists of a light source constituted by, for example, a lamp (for example, a mercury lamp, a mercury-xenon lamp, a deuterium lamp, a xenon lamp, an inert gas lamp or a rare gas lamp) or a laser (for example, an excimer laser, an argon laser, a CO₂ laser, a dye laser, a YAG laser or a free electron laser) and synchrotron radiation, and is configured so that light from the light source is led to the reaction chamber via appropriate optical elements, such as mirrors and lenses, to excite the reaction gas and promote a chemical reaction. The photo-excitation process can enable the reaction to proceed at a low temperature, even at room temperature. Compared with other methods there is very little radiation damage, and by selecting an appropriate wavelength the reaction can be performed with no damage.

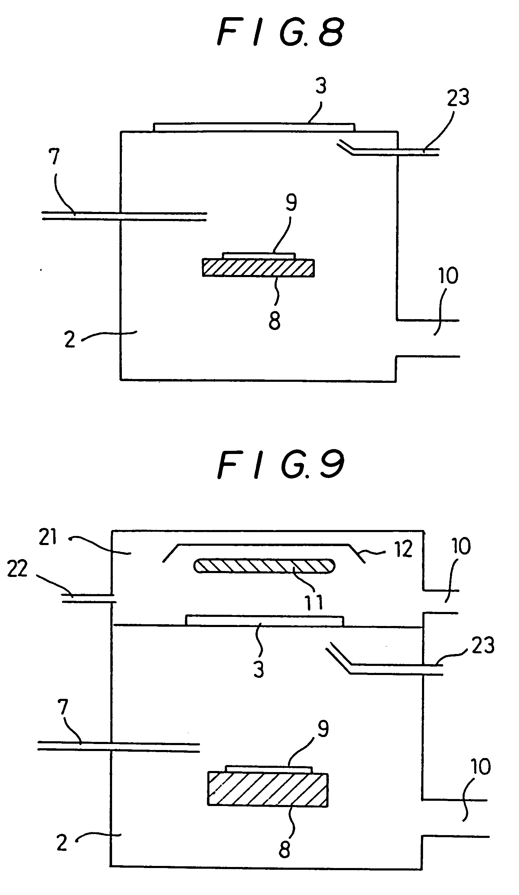

Conventional arrangements for photo-excitation processes are shown in Figures 8 and 9. In Figure 8, numeral 2 denotes a gas reaction chamber where gas reaction is performed and 3 a light transmitting window provided at the top part of the gas reaction chamber 2. A light source is provided above the light transmitting window 3. A reaction gas inlet 7 is provided in the body wall of the gas reaction chamber 2. A substrate holder 8 is attached inside the gas reaction chamber 2 by an appropriate means (not shown). Numeral 9 denotes a substrate which is placed on the substrate holder 8. An exhaust outlet 10 is provided at the lower part of the gas reaction chamber 2 and is connected to a vacuum pump. A window-spray gas inlet 23 is provided in the upper body wall of the gas reaction chamber 2 with the supply opening pointing upward at an angle. In the example of the conventional configuration shown in Figure 8, the light emitted by an external light source passes through the light transmitting window 3, which shuts off the atmosphere, and excites the reaction gas introduced via the reaction gas inlet 7 provided in the body wall of the gas reaction chamber 2, whereby a photochemical reaction takes place on the substrate 9 in the gas reaction chamber 2. However, because the reaction gas is also in contact with the lower surface of the light transmitting window 3, the reaction gas also produces a photochemical reaction on the lower surface of the light transmitting window 3. The reaction gas which has completed the chemical reaction is evacuated to the outside by a vacuum pump via the exhaust outlet 10.

With reference to Figure 9, a light source chamber 21 is formed in the top part of the gas reaction chamber 2. A light source 11 is attached inside the light source chamber 21 by an appropriate means (not shown). A mirror 12 is attached by an appropriate means (not shown) between the light source 11 and the top face of the light source chamber 21. A purge gas inlet 22 is provided in the side wall of the light source chamber 21. An exhaust outlet 10 is provided in the side wall of the light source chamber 21 opposite to the side wall in which the purge gas inlet 22 is provided. Elements denoted by reference numerals 3, 7, 8, 9, 10 and 23 in the gas reaction chamber 2 at the lower part of the light source chamber 21 are the same as the correspondingly denoted elements in Figure 8.

In the example of the conventional configuration shown in Figure 9, direct light from the light source 11 provided in the light source chamber 21 in which gas is replaced by purge gas introduced via the purge gas inlet 22, and light reflected by the mirror 12, passes through the light transmitting window 3 and excites the reaction gas introduced via the reaction gas inlet 7 provided in the body wall of the gas reaction chamber 2 and produces a photochemical reaction on the substrate 9 in the gas reaction chamber 2. However, as in the case described above, because the reaction gas is also in contact with the lower surface of the light transmitting window 3, the reaction gas also produces a photochemical reaction on the lower surface of the light transmitting window 3.

In the case of each of the arrangements shown in Figures 8 and 9, a photochemical reaction is produced on the lower surface of the light transmitting window 3 that results in the contamination of the lower surface of the light transmitting window 3. As the film of contamination becomes thicker it limits the amount of light that is transmitted from the light source to the gas reaction chamber 2, thereby inhibiting the photochemical reaction in the gas reaction chamber 2. Described below are conventional methods used to prevent such a film forming on the light transmitting window 3.
1. Spraying inert gas on the light transmitting window 3 (with reference to Figures 8 and 9, the spraying on the light transmitting window 3 with inert gas from the gas inlet 23).
2. Coating the light transmitting window 3 with a fluoride oil.
3. Inserting a heavily perforated quartz plate or a Teflon (Registered Trade Mark) film winder under the light transmitting window 3.

However, these methods have the following problems. In the first method in which inert gas is sprayed on the light transmitting window 3, spraying a large amount of inert gas on to a light transmitting window 3 with a large area produces turbulence that makes it impossible to avoid reaction gas being drawn in, which results in the deposition of said film on the light transmitting window 3. In the case of the second method in which the light transmitting window 3 is coated with a fluoride oil, because the fluoride oil is decomposed by the light, over long periods of use (for example 30 min) it is not able to prevent the deposition of the film on the light transmitting window 3. In the case of the third method which involves inserting a heavily perforated quartz plate or a Teflon film winder under the light transmitting window 3, the overall amount of transmitted light is reduced and the size of the apparatus is increased.

US-A-4 649 859 employs reaction gases for the purpose of mixing gas components in CVD (chemical vapor deposition) apparatus to deposit uniform films on a substrate, window cleaning means not being provided. In addition, a vortex flow is only formed on the substrate by convection currents due to substrate heating.

According to the present invention from one aspect, there is provided apparatus for use in manufacturing a semiconductor device by a photo-excitation process or a plasma process, comprising:-
(a) a purge gas chamber having a centre axis parallel to a side wall of the purge gas chamber and about which axis a revolving laminar gas flow of purge gas is provided, and a gas reaction chamber where gas reaction is performed, said purge gas chamber being located adjacent a body portion of said gas reaction chamber;
(b) a plurality of purge gas inlets to said purge gas chamber located at said side wall of said purge gas chamber, each of said purge gas inlets having an axis normal to its cross-section and each of said purge gas inlets being oriented at an angle such that the axes of said purge gas inlets do not intersect said centre axis of said purge gas chamber, so as to control the gas flow in the purge gas chamber to form a revolving laminar gas flow in that chamber in a direction around the centre axis thereof and into the gas reaction chamber;
(c) a partition having a centrally located circular opening disposed between said purge gas chamber and said gas reaction chamber;
(d) an internal or external light source with respect to said purge gas chamber, to provide light to said gas reaction chamber through said purge gas chamber; and
(e) at least one reaction gas inlet in a body wall of said gas reaction chamber, an exhaust outlet from said gas reaction chamber connected to a vacuum pump and a substrate holder in said gas reaction chamber between the reaction gas inlet(s) and the exhaust outlet.

According to the present invention from another aspect there is provided apparatus for use in manufacturing a semiconductor device by a photo-excitation process or a plasma process, the apparatus comprising:-
(a) a purge gas chamber having a centre axis parallel to a side wall of the purge gas chamber and about which axis a revolving laminar gas flow of purge gas is provided, and a gas reaction chamber, said purge gas chamber being located adjacent a body portion of said gas reaction chamber and said purge gas chamber being smaller than said gas reaction chamber and having no partition between said purge gas chamber and said gas reaction chamber;
(b) a plurality of purge gas inlets to said purge gas chamber located at said side wall of said purge gas chamber, each of said purge gas inlets having an axis normal to its cross-section and each of said purge gas inlets being oriented at an angle such that the axes of said purge gas inlets do not intersect said centre axis of said purge gas chamber so as to control the gas flow in the purge gas chamber to form a revolving laminar gas flow in that chamber in a direction around the centre axis thereof and into the gas reaction chamber;
(c) an internal or external light source with respect to said purge gas chamber, to provide light to said gas reaction chamber through said purge gas chamber, or a microwave or radio frequency source, to provide microwave or radio frequency energy to said gas reaction chamber through said purge gas chamber; and
(d) at least one reaction gas inlet in a body wall of said gas reaction chamber, an exhaust outlet from said gas reaction chamber connected to a vacuum pump and a substrate holder in said gas reaction chamber between the reaction gas inlet(s) and the exhaust outlet.

The present invention will now be described, by way of example, with reference to the accompanying drawings in which:-
Figure 1 is a view of a photo-excitation process apparatus with an external light source;
Figure 2 is a view of a photo-excitation process apparatus with an internal light source;
Figure 3 is a view of a photo-excitation process (or plasma process) apparatus with internal discharge electrodes;
Figure 4 is a view of photo-excitation process (or plasma process) apparatus with an external microwave power source (or a radio-frequency power source);
Figure 5 is a view of an experimental apparatus for flow visualisation in which the gas flow is made visible;
Figure 6 is a plan view of the pattern produced by an experiment with the arrangement shown in Figure 5;
Figure 7 is a side view of the pattern produced by an experiment with the arrangement shown in Figure 5;
Figure 8 is a view of a conventional apparatus with an external light source; and
Figure 9 is a view of a conventional apparatus with an internal light source.

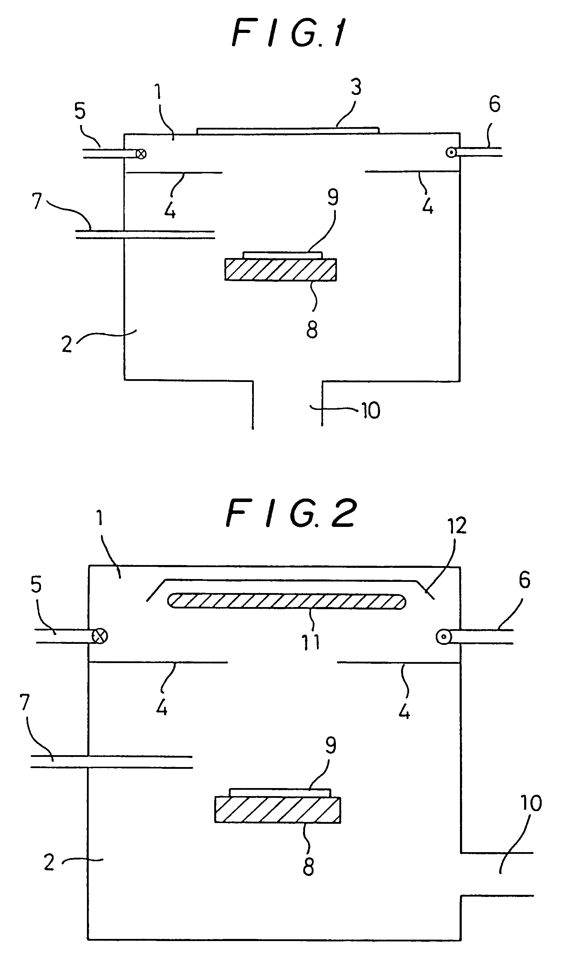

With reference to Figure 1, which shows a photo-excitation process apparatus with an external light source, the top part forms a cylindrical purge gas chamber 1 having a centre axis and in which a revolving laminar gas flow is formed about the centre axis and the lower part forms a gas reaction chamber 2, a partition 4 having a centrally located circular opening being provided between the purge gas chamber 1 and the gas reaction chamber 2. A light transmitting window 3 is provided at the top part of the purge gas chamber 1. A light source (not shown) is provided above the light transmitting window 3. Numerals 5 and 6 denote purge gas inlets which are provided at the side wall of the purge gas chamber 1, the side wall being parallel to the centre axis of the purge gas chamber. The purge gas inlets 5 and 6 have axes normal to their cross-sections, these axes not intersecting the centre axis of the purge gas chamber 1. In this embodiment, one gas inlet is provided at the opposite side to the other, separated by 180°, and the orientation is such as to produce a clockwise flow of gas. That is, with reference to the drawing, the purge gas inlet 5 faces toward the back surface of the drawing and the purge gas inlet 6 faces away from the surface of the drawing. Purge gas introduced into the purge gas chamber 1 via purge gas inlets 5 and 6 moves along the inner surface of the wall of purge gas chamber 1 to produce a revolving laminar gas flow. As a partition 4 having a centrally located opening is provided between chamber 1 and chamber 2, the revolving laminar gas flow formed in chamber 1 is consolidated by the opening in partition 4 and descends into the chamber 2 while rotating. Numeral 7 denotes a reaction gas inlet provided in the body wall of the gas reaction chamber 2. A substrate holder 8 is attached inside the gas reaction chamber 2 by appropriate means (not shown). Numeral 9 denotes a substrate which is placed on the substrate holder 8. The reaction gas inlet 7 is provided at a position that is higher than the substrate 9. Provided at the lower part of the gas reaction chamber 2 is an exhaust outlet 10 that is connected to a vacuum pump (not shown).

With reference to Figure 2, a light source 11 is attached inside the purge gas chamber 1 by appropriate means (not shown). A mirror 12 is attached by appropriate means (not shown) between the light source 11 and the top face of the purge gas chamber 1, in this embodiment, there being no light transmitting window 3. Otherwise except for the way an exhaust outlet 10 is provided at the lower part of a body wall of the gas reaction chamber 2, the arrangement is the same as that of Figure 1.

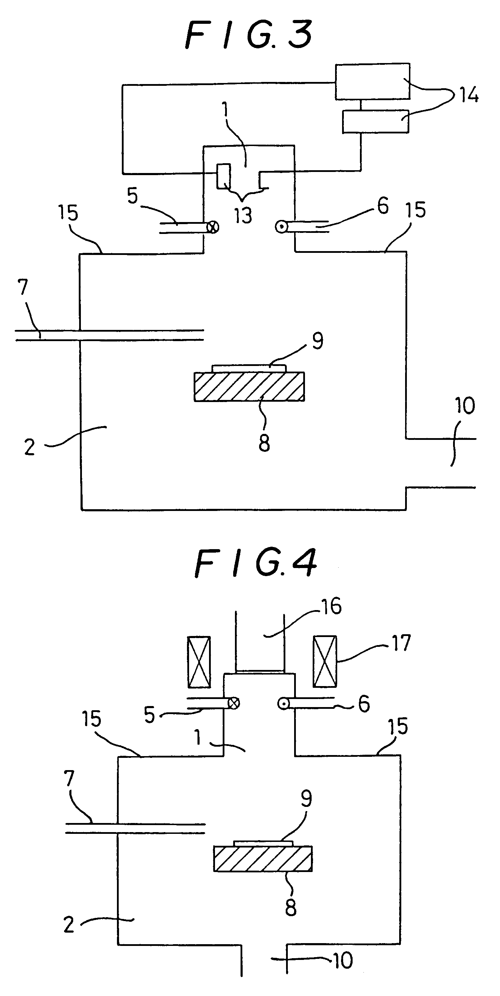

The arrangement shown in Figure 3 is when the purge gas chamber 1 is smaller than the gas reaction chamber 2 and discharge electrodes 13 are provided inside the purge gas chamber 1. Numeral 14 denotes an external AC and DC power source. Numeral 15 denotes the top face of the gas reaction chamber 2 which is provided with a central opening having a cross-section as large as the gas chamber 1. In this embodiment, there is no light transmitting window 3 or partition 4. Otherwise, except for the way an exhaust outlet 10 is provided at the lower part of a body wall of the gas reaction chamber 2, the arrangement is the same as that of Figure 1.

The arrangement shown in Figure 4 is when the purge gas chamber 1 is smaller than the gas reaction chamber 2, and a microwave (or radio-frequency) discharge guide 16 and a field coil 17 are provided outside the purge gas chamber 1. Except for the absence of a light transmitting window 3 and a partition 4, the arrangement is the same as that of Figure 1. The present invention is not limited to a photo-excitation process, but may also be employed with a conventional plasma process to produce the uniform gas flow on the substrate.

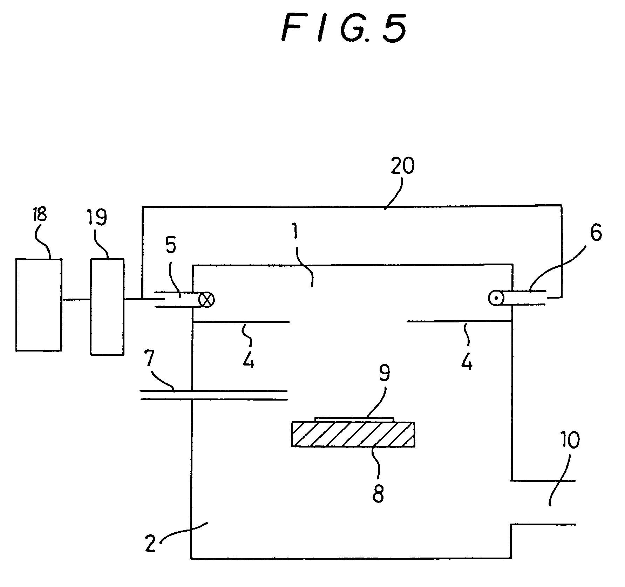

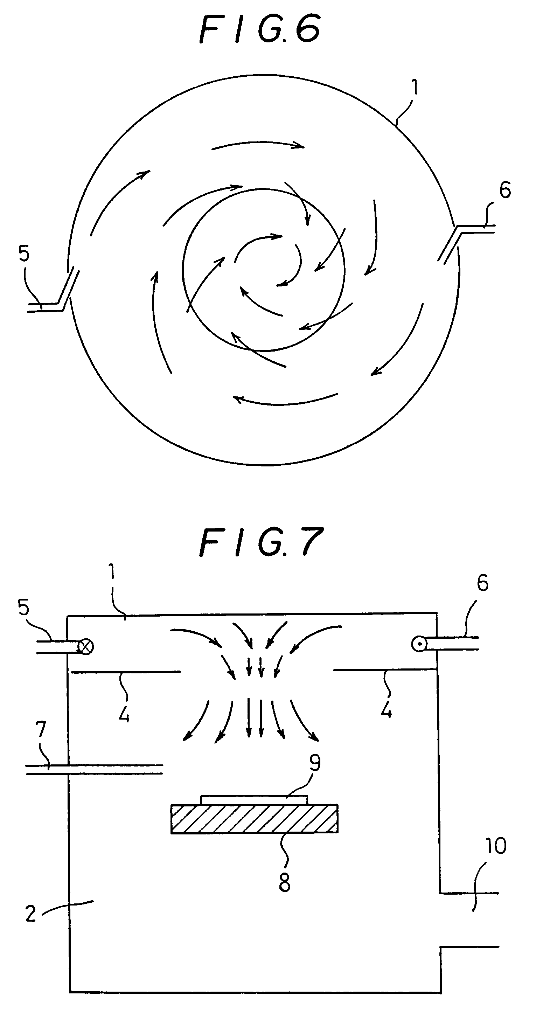

In Figure 5, a dry-ice mist generator 18 is connected to the purge gas inlet 5 by means of a drip trap 19, and is also connected to the purge gas inlet 6 by means of an external pipe 20. There is no light transmitting window 3, and except for the way an exhaust outlet 10 is provided at the lower part of a body wall of the gas reaction chamber 2, the arrangement is the same as that of Figure 1. The back pressure is 1.3 Pa (10⁻² Torr). The purge gas chamber 1 and gas reaction chamber 2 are constituted of transparent material to enable the interior to be viewed. The purge gas inlets are oriented at an angle of about 70° with respect to the centre axis of the purge gas chamber 1, to produce a clockwise flow of gas. In Figures 6 and 7, the arrows indicate laminar gas flow.

The operation of the embodiments configured as described above will now be described. The embodiment shown in Figure 1 has an external light source. Before starting the photochemical reaction, the purge gas chamber 1 and gas reaction chamber 2 are purged of air. The purge gas used is usually inert gas and carrier gas such as hydrogen, nitrogen or oxygen.

After the purge gas chamber 1 and gas reaction chamber 2 have been purged, the light source is used to emit light into the purge gas chamber 1 via the light transmitting window 3 which shuts out the outside atmosphere. Any of the light sources described above may be used; in this embodiment a mercury lamp is used. Gas introduced into the purge gas chamber 1 by the purge gas inlets 5 and 6 provided in the side wall of the purge gas chamber 1 is formed into a clockwise revolving laminar gas flow in the purge gas chamber 1 by the orientation of the purge gas inlets 5 and 6 which are angled to produce a clockwise flow of gas. The purge gas inlets 5 and 6 may also be oriented to produce a counter-clockwise flow. The gas introduced via the purge gas inlets 5 and 6 may be any gas that does not give rise to a chemical reaction in the purge gas chamber 1, such as for example, an inert gas, hydrogen, oxygen, nitrogen, carbon dioxide gas, rare gas, chloride gas, fluoride gas, nitride gas or halogen gas. In this embodiment, oxygen gas diluted with argon is used.

The revolving laminar gas flow formed in the purge gas chamber 1 is narrowed down by the partition 4, and therefore flows into the gas reaction chamber 2 as it is, without disturbance of the laminar flow. The reaction gas introduced via the reaction gas inlet 7 forms a gas layer above the substrate 9 with the revolving laminar gas flow, to constitute an overall flow. This gas layer is excited by the light passing through the purge gas chamber 1 and reaching the gas reaction chamber 2, producing a photochemical reaction on the substrate 9. The reaction gas is then drawn off through the exhaust outlet 10 by a vacuum pump and evacuated to the outside.

In this embodiment, the reaction gas used is SiH₄, which results in the formation of a layer of SiO₂ on the substrate 9. The substrate 9 is a silicon wafer. There are many possible types of reaction gas and substrate, any of which may be used. Because when AsH₃ or PH₃ or the like is used for reaction gas a chemical reaction does not readily take place in the purge gas chamber, the gas introduced into the purge gas inlets in the purge gas chamber 1 can be made the same as the reaction gas. In this case, because the reaction gas already has been excited in the purge gas chamber 1, it also has the effect of increasing the speed of the reaction in the gas reaction chamber 2.

The embodiment shown in Figure 2, in which the light source is internal, operates in the same way as described above. As the laminar gas flow revolves during its descent there is no turbulence, and the light source is not contaminated by the photochemical reaction. In addition, because in this case the light source is internal, an intense light can be obtained.

In the arrangement shown in Figure 3, the purge gas chamber is smaller than the gas reaction chamber. Because the purge gas chamber is smaller, even when the gas is evacuated by a vacuum pump via the exhaust outlet 10, the gas formed into a revolving laminar gas flow in the purge gas chamber 1 descends into the gas reaction chamber 2 without any disturbance of the laminar flow. Because in this case the discharge is internal, an intense light can be obtained. As in this case, also, the laminar gas flow revolves during its decent, the discharge electrodes are not contaminated by the photochemical reaction. This arrangement is also suitable for use with a plasma process.

In the arrangement shown in Figure 4, the discharge source for the light source is provided externally; except for the inclusion of a microwave (or radio-frequency) discharge guide 16, the arrangement is the same as that illustrated in Figure 3. Also, in the case of processes other than photo-excitation processes such as the plasma process, the purge gas chamber 1 is not contaminated by the photochemical reaction or plasma because the laminar gas flow revolves as it descends.

Although the embodiments illustrated in Figures 1 to 4 have been described as vertical types, the same effect may be obtained with a horizontal configuration.

The result of the gas flow visualisation experiment illustrated in Figure 5 was that a dry-ice mist introduced into the purge gas chamber 1 via 18, 19 and 20 was observed to form a revolving laminar gas flow and revolve in a regular fashion, when viewed from above, as in Figure 6. The conditions were as follows. Pressure: 1.33 x 10⁴ Pa (100 Torr); Reynolds number: 1120; dry-ice mist flow rate: about 400 cm³/min. Regarding the flow of gas from the purge gas chamber 1 to the gas reaction chamber 2 during the experiment, as shown in Figure 7, the mist was observed to descend in an orderly fashion. Because with the method according to this invention the laminar gas flow revolves during the descent, there is no back flow.

Thus, as has been described above, because the present invention provides a revolving laminar gas flow, the process reaction on the substrate can be made highly uniform, enabling a photochemical reaction of stable quality to be carried out. The speed of the flow toward the substrate can also be made uniform. The revolving laminar gas flow produced in the purge gas chamber descends into the gas reaction chamber 2 without undergoing any change, which has the effect of providing the same uniform chemical reaction on the substrate as would be provided by rotating the substrate holder. As such, it also eliminates the need to provide a means of rotating the substrate.

In addition, because the revolving of the laminar gas flow during the descent also prevents a light transmitting window from becoming contaminated as a result of the photochemical reaction, continuous operation for extended periods becomes possible. It also means that the area of the light transmitting window can be made larger compared with the conventional arrangements, and the increased amount of photon flux thereby transmitted by the window helps to raise the efficiency of the reaction. Similarly, when the light source is internal, as shown in Figure 2, the photochemical reaction does not take place at the light source, so the light source does not become contaminated. Also, the simplicity of the method and construction required to provide the revolving laminar gas flow enable the apparatus to be fabricated at a low cost. Furthermore, because only the minimal amount of gas needed to obtain a revolving laminar gas flow is required, less gas is used than in the conventional method in which a large amount of gas is used to prevent the light transmitting window from becoming contaminated. Because the reaction gas, carrier gas and doping gas can be prevented from mixing in the purge gas chamber in this method, a one-chamber configuration can be used in place of the multi-chamber configurations of conventional apparatuses where contamination is a big problem.

## Claims

1. Apparatus for use in manufacturing a semiconductor device by a photo-excitation process or a plasma process, the apparatus comprising:-
(a) a purge gas chamber (1) having a centre axis parallel to a side wall of the purge gas chamber and about which axis a revolving laminar gas flow of purge gas is provided, and a gas reaction chamber (2) where gas reaction is performed, said purge gas chamber being located adjacent a body portion of said gas reaction chamber;
(b) a plurality of purge gas inlets (5,6) to said purge gas chamber located at said side wall of said purge gas chamber, each of said purge gas inlets having an axis normal to its cross-section and each of said purge gas inlets being orientated at an angle such that the axes of said purge gas inlets do not intersect said centre axis of said purge gas chamber, so as to control the gas flow in the purge gas chamber to form a revolving laminar gas flow in that chamber in a direction around the centre axis thereof and into the gas reaction chamber;
(c) a partition (4) having a centrally located circular opening disposed between said purge gas chamber and said gas reaction chamber;
(d) an internal or external light source (11) with respect to said purge gas chamber, to provide light to said gas reaction chamber through said purge gas chamber; and
(e) at least one reaction gas inlet (7) in a body wall of said gas reaction chamber, an exhaust outlet (10) from said gas reaction chamber connected to a vacuum pump and a substrate holder (8) in said gas reaction chamber between the reaction gas inlet(s) and the exhaust outlet.

2. Apparatus according to claim 1, wherein a light window (3) is provided at an end portion of said purge gas chamber (1), the light source being external with respect to said purge gas chamber.

3. Apparatus for use in manufacturing a semiconductor device by a photo-excitation process or a plasma process, the apparatus comprising:-
(a) a purge gas chamber (1) having a centre axis parallel to a side wall of the purge gas chamber and about which axis a revolving laminar gas flow of purge gas is provided, and a gas reaction chamber (2), said purge gas chamber being located adjacent a body portion of said gas reaction chamber and said purge gas chamber being smaller than said gas reaction chamber and having no partition between said purge gas chamber and said gas reaction chamber;
(b) a plurality of purge gas inlets (5,6) to said purge gas chamber located at said side wall of said purge gas chamber, each of said purge gas inlets having an axis normal to its cross-section and each of said purge gas inlets being oriented at an angle such that the axes of said purge gas inlets do not intersect said centre axis of said purge gas chamber, so as to control the gas flow in the purge gas chamber to form a revolving laminar gas flow in that chamber in a direction around the centre axis thereof and into the gas reaction chamber;
(c) an internal or external light source (13,14) with respect to said purge gas chamber, to provide light to said gas reaction chamber through said purge gas chamber, or a microwave or radio frequency source (16,17), to provide microwave or radio frequency energy to said gas reaction chamber through said purge gas chamber; and
(d) at least one reaction gas inlet (7) in a body wall of said gas reaction chamber, an exhaust outlet (10) from said gas reaction chamber connected to a vacuum pump and a substrate holder (8) in said gas reaction chamber between the reaction gas inlet(s) and the exhaust outlet.

4. Apparatus according to any preceding claim, wherein said purge gas chamber (1) is located above said gas reaction chamber (2) in a vertical configuration.

5. Apparatus according to any of claims 1 to 3, wherein said purge gas chamber (1) is located alongside said gas reaction chamber (2) in horizontal configuration.

## Patentansprüche

1. Anlage zur Herstellung einer Halbleitervorrichtung durch einen Photoanregungsprozeß oder einen Plasmaprozeß, **gekennzeichnet, durch**
a) eine Reinigungsgaskammer (1) mit einer zentralen Achse parallel zur Seitenwand der Reinigungsgaskammer, um welche Achse eine umlaufende laminare Reinigungsgasströmung erzeugt wird, und eine Gasreaktionskammer (2), in der eine Gasreaktion durchgeführt wird, wobei die Gasreinigungskammer nahe einem Teil der Gasreaktionskammer liegt;
b) mehrere Reinigungsgaseinlässe (5, 6) zur Reinigungsgaskammer, die an der Seitenwand der Reinigungsgaskammer liegen, wobei jeder Reinigungsgaseinlaß eine Achse senkrecht zu seinem Querschnitt hat und jeder Reinigungsgaseinlaß unter einem Winkel derart orietiert ist, daß die Achsen der Reinigungsgaseinlässe die zentrale Achse der Reinigungsgaskammer nicht schneiden, um die Gasströmung in der Gasreinigungsgaskammer zu steuern und eine umlaufende laminare Gasströmung in der Kammer in einer Richtung um deren zentrale Achse und in die Gasreaktionskammer zu erzeugen;
c) eine Trennwand (4) mit einer zentralen kreisförmigen Öffnung, die zwischen der Reinigungsgaskammer und der Gasreaktionskammer liegt;
d) eine bezüglich der Reinigungsgaskammer interne oder externe Lichtquelle (11), um der Gasreaktionskammer durch die Reinigungsgaskammer Licht zuzuführen und
e) wenigstens einen Reaktionsgaseinlaß (7) in einer Wand der Gasreaktionskammer, einen Absaugauslaß (10) aus der Gasreaktionskammer, der mit einer Vakuumpumpe verbunden ist, und einen Substrathalter in der Gasreaktionskammer zwischen dem Reaktionsgaseinlaß bzw. den Reaktionsgaseinlässen und dem Absaugauslaß.

2. Anlage nach Anspruch 1,
**gekennzeichnet, durch**
ein Lichtfenster (3) an einem Endteil der Gasreinigungskammer (1), wobei die Lichtquelle bezüglich der Gasreinigungskammer extern ist.

3. Anlage zur Herstellung einer Halbleitervorrichtung durch einen Photoanregungsprozeß oder einen Plasmaprozeß
**gekennzeichnet, durch**
a) eine Gasreinigungskammer (1), die eine zentrale Achse parallel zur Seitenwand der Reinigungsgaskammer hat, um welche Achse eine umlaufende laminare Reinigungsgasströmung erzeugt wird, und eine Gasreinigungskammer (2), wobei die Gasreinigungskammer nahe einem Teil der Gasreinigungskammer liegt und die Gasreinigungskammer kleiner als die Gasreaktionskammer ist und keine Trennwand zwischen der Reinigungsgaskammer und der Gasreaktionskammer vorhanden ist;
b) mehrere Reinigungsgaseinlässe (5, 6) zur Gasreinigungskammer, die an der Seitenwand der Reinigungsgaskammer liegen, wobei jeder Reinigungsgaseinlaß eine Achse senkrecht zu seinem Querschnitt hat und jeder Reinigungsgaseinlaß unter einem Winkel derart orientiert ist, daß die Achsen der Reinigungsgaseinlässe die zentrale Achse der Reinigungsgaskammer nicht schneiden, um die Gasströmung in der Reinigungsgaskammer zu steuern und eine umlaufende laminare Gasströmung in der Kammer in einer Richtung um deren zentrale Achse und in die Gasreaktionskammer zu erzeugen;
c) eine bezüglich der Reinigungsgaskammer interne oder externe Lichtquelle (13, 14), um der Gasreaktionskammer durch die Reinigungsgaskammer Licht zuzuführen, oder eine Mikrowellen- oder HF-Quelle (16, 17), um eine Mikrowellen- oder HF-Energie der Gasreaktionskammer durch die Reinigungsgaskammer zuzuführen; und
d) wenigstens einen Reaktionsgaseinlaß (7) in der Wand der Gasreaktionskammer, einen Absaugauslaß (10) aus der Gasreaktionskammer, der mit einer Vakuumpumpe verbunden ist, und eine Substrathalter (8) in der Gasreaktionskammer zwischen dem Reaktionsgaseinlaß bzw. den Reaktionsgaseinlässen und dem Absaugauslaß.

4. Anlage nach einem der vorhergehenden Ansprüche,
**dadurch gekennzeichnet, daß**
die Reinigungsgaskammer (1) oberhalb der Gasreaktionskammer (2) in vertikaler Anordnung liegt.

5. Anlage nach einem Ansprüche 1 bis 3,
**dadurch gekennzeichnet, daß**
die Reinigungsgaskammer (1) längs der Gasreaktionskammer (2) in horizontaler Anordnung liegt.

## Revendications

1. Appareil utilisable pour la fabrication de dispositifs semi-conducteurs par un procédé de photo-excitation ou un procédé à plasma, comprenant :
(a) une chambre à gaz de purge (1) présentant un axe central parallèle à une paroi latérale de la chambre à gaz de purge et autour duquel s'établit un flux laminaire tournant de gaz de purge, et une chambre (2) de réaction en phase gazeuse où la réaction gazeuse a lieu, la chambre à gaz de purge étant située en position adjacente à une partie du corps de la chambre de réaction en phase gazeuse ;
(b) une pluralité d'entrées (5,6) de gaz de purge vers la chambre à gaz de purge placées sur la paroi latérale de la chambre à gaz de purge, chacune des entrées de gaz de purge ayant un axe normal à sa section en coupe et chacune des entrées à gaz de purge étant orientée selon un angle bel que les axes de ces entrées à gaz de purge ne coupent pas l'axe central de la chambre à gaz de purge, afin de contrôler le flux gazeux dans la chambre à gaz de purge pour former un flux de gaz laminaire tournant dans cette chambre selon une direction autour de son axe central et vers la chambre de réaction en phase gazeuse ;
(c) une séparation (4) présentant une ouverture circulaire disposée centralement, placée entre la chambre à gaz de purge et la chambre de réaction en phase gazeuse ;
(d) une source lumineuse interne ou externe (11) par rapport à la chambre à gaz de purge, pour fournir de la lumière à la chambre de réaction en phase gazeuse à travers la chambre à gaz de purge ;
(e) au moins une entrée (7) pour le gaz de réaction dans la paroi du corps de la chambre de réaction en phase gazeuse, une sortie (10) d'échappement pour la chambre de réaction en phase gazeuse reliée à une pompe à vide et un support (8) de substrat dans la chambre de réaction en phase gazeuse entre l'/es entrée(s) du gaz de réaction et la sortie d'échappement.

2. Appareil selon la revendication 1, dans lequel la fenêtre de lumière (3) est placée sur une extrémité de la chambre à gaz de purge (1), la source lumineuse étant externe par rapport à la chambre à gaz de purge.

3. Appareil utilisable pour la fabrication de dispositifs semi-conducteurs par un procédé de photo-excitation ou un procédé à plasma, comprenant :
(a) une chambre (1) à gaz de purge présentant un axe central parallèle à une paroi latérale de la chambre à gaz de purge et autour duquel s'établit un flux laminaire tournant de gaz de purge, et une chambre (2) de réaction en phase gazeuse, la chambre à gaz de purge étant située en position adjacente à une partie du corps de la chambre de réaction en phase gazeuse et la chambre à gaz de purge étant plus petite que la chambre de réaction en phase gazeuse et ne présentant pas de séparation entre la chambre à gaz de purge et la chambre de réaction en phase gazeuse ;
(b) une pluralité d'entrées (5,6) de gaz de purge vers la chambre à gaz de purge placées sur la paroi latérale de la chambre à gaz de purge, chacune des entrées de gaz de purge ayant un axe normal à sa section en coupe et chacune des entrées à gaz de purge étant orientée selon un angle tel que les axes de ces entrées à gaz de purge ne coupent pas l'axe central de la chambre à gaz de purge, afin de contrôler le flux gazeux dans la chambre à gaz de purge pour former un flux de gaz laminaire tournant dans cette chambre selon une direction autour de son axe central et vers la chambre de réaction en phase gazeuse ;
(c) une source lumineuse interne ou externe (13,14) par rapport à la chambre à gaz de purge, pour fournir de la lumière à la chambre de réaction en phase gazeuse à travers la chambre à gaz de purge, ou une source micro-onde ou radio-fréquence pour fournir une énergie micro-onde ou radio-fréquence à la chambre de réaction en phase gazeuse à travers la chambre à gaz de purge ; et
(d) au moins une entrée (7) pour le gaz de réaction dans la paroi du corps de la chambre de réaction en phase gazeuse, une sortie (10) d'échappement pour la chambre de réaction en phase gazeuse reliée à une pompe à vide et un support (8) de substrat dans la chambre de réaction en phase gazeuse entre l'/es entrée(s) du gaz de réaction et la sortie d'échappement.

4. Appareil selon l'une des revendications précédentes, dans lequel la chambre à gaz de purge (1) est placée au-dessus de la chambre (2) de réaction en phase gazeuse en configuration verticale.

5. Appareil selon l'une des revendications 1 à 3, dans lequel la chambre à gaz de purge (1) est placée le long de la chambre (2) de réaction en phase gazeuse en configuration horizontale.
